**Europäisches Patentamt**

**European Patent Office**

**Office européen des brevets**

(19)

(11) Veröffentlichungsnummer: **0 021 027**
**B1**

(12)

# EUROPÄISCHE PATENTSCHRIFT

(45) Veröffentlichungstag der Patentschrift:
**06.04.83**

(21) Anmeldenummer: **80102770.7**

(22) Anmeldetag: **20.05.80**

(51) Int. Cl.³: **H 01 L 31/02**

(54) **Solarzellen-Anordnung.**

(30) Priorität: **03.07.79 DE 2926754**

(43) Veröffentlichungstag der Anmeldung:
**07.01.81 Patentblatt 81/1**

(45) Bekanntmachung des Hinweises auf die Patenterteilung:
**06.04.83 Patentblatt 83/14**

(84) Benannte Vertragsstaaten:
**AT FR GB IT NL**

(56) Entgegenhaltungen:
**DE-A-2 712 038**
**US-A-4 118 249**

**THE CONFERENCE RECORD OF THE «TWELFTH IEEE
PHOTOVOLTAIC SPECIALISTES CONFERENCE - 1976»,
15.-18. November 1976, Seiten 764-770 Baton Rouge,
Louisiana, U.S.A.**
**A. GORSKI et al.: «Novel versions of the compound parabolic concentrator for photovoltaic power generation»**

(73) Patentinhaber: **Licentia Patent-Verwaltungs-GmbH,
Theodor-Stern-Kai 1, D-6000 Frankfurt/Main 70 (DE)**

(72) Erfinder: **Dahlberg, Reinhard, Dr., Innere Bergstrasse 32,
D-7101 Flein (DE)**

(74) Vertreter: **Maute, Hans-Jürgen, Dipl.-Ing. et al, Licentia
Patent-Verwaltungs-GmbH Theodor-Stern-Kai 1,
D-6000 Frankfurt/Main 70 (DE)**

## Solarzellen-Anordnung

Die Erfindung betrifft eine Solarzellen-Anordnung, aus mindestens zwei getrennten Platten oder Scheiben, wobei eine Platte oder Scheibe (1) aus lichtdurchlässigem Material besteht, deren eine Seite eine regelmäßige Struktur von lichtdurchlässigen Erhebungen (3) trägt. Diese Anordnung dient der Umwandlung von Sonnenenergie mit hohem Wirkungsgrad und niedrigen Kosten.

Das Hauptproblem der terrestrischen Anwendung von Solarzellen liegt bekanntlich in der Herstellung einer hinreichend billigen Solarzelle mit möglichst hohem Wirkungsgrad. Da den Kosten des Siliziums dabei eine Schlüsselrolle zukommt, fehlt es nicht an Versuchen, vom teuren einkristallinen Material loszukommen und polykristallines oder amorphes Silizium für Solarzellen zu verwenden. Leider ergeben Solarzellen aus diesen Materialien schlechte Wirkungsgrade.

Einen wesentlichen Fortschritt zur Verbesserung des Wirkungsgrades von polykristallinen Solarzellen stellt das Konzept der MIS- und MISIM-Solarzellen dar; M. A. Green and R. B. Godfrey «The MIS and MISIM Solar Cell» Proceedings of the 1st International Photovoltaic Solar Energieconference Sept. 27 - 30, 1977, S. 299 - 307. Dabei steht M für Metall, I für eine sehr dünne Isolatorschicht und S für Halbleiter. Bei diesen Strukturen ist die Korngrenzen-Rekombination des polykristallinen Materials weitgehend ausgeschaltet. Eine weitere Maßnahme zur Erhöhung des Wirkungsgrades einer Solarzelle ist die Konzentration und Erhöhung der Intensität des einfallenden Sonnenlichtes. Da der Temperaturkoeffizient für maximale Leistung bei einer Siliziumsolarzelle aber etwa - 0,5% pro Grad beträgt, geht der Wirkungsgrad bei Erwärmung der Solarzelle von 0°C bis 100°C auf etwa 50% zurück. Aus diesem Grunde muß bei konzentriertem Sonnenlicht eine zuverlässige Kühlung der Solarzelle erfolgen. Diese zusätzliche Kühlung und die Mittel zur Konzentration des Sonnenlichtes verursachen zusätzliche Kosten.

Aus der US-PS 4118249 ist eine Solarzellen-Anordnung bekannt, bei der auf einer Trägerplatte eine Vielzahl von elektrisch funktionsfähigen Einzel-Solarzellen angeordnet sind. Auf die Gesamtanordnung wird eine der Lichtkonzentration auf die Einzel-Solarzellen dienende Deckplatte aufgelegt, die aus jeweils einer Solarzelle zugeordneten Einzelsegmenten zusammengesetzt ist. Der Querschnitt jedes Einzelsegments ist an der Berührungsstelle mit der Solarzelle kleiner als an der Plattenoberfläche.

Die Erfindung beschreibt eine Solarzelle, bei welcher eine Konzentration des Sonnenlichtes an der Solarzelle selbst geschieht, und bei welcher ohne zusätztliche Kühlung praktisch keine zusätzliche Erwärmung der Solarzelle durch das konzentrierte Sonnenlicht verursacht wird.

Diese Aufgabe wird bei einer Solarzellen-Anordnung der eingangs erwähnten Art erfindungsgemäß dadurch gelöst, daß sich die Erhebungen parabolisch verjüngen, daß diese parabolischen Erhebungen in der Höhe ihrer Brennpunkte oder ihrer Brennlinien parallel zur Oberfläche der Platte oder Scheibe abgeschnitten sind, daß die Oberfläche der parabolischen Erhebungen mit einer mindestens teilweise lichtdurchlässigen elektrisch leitenden Schicht überzogen ist, daß die zweite Platte oder Scheibe der Anordnung aus Halbleitermaterial oder aus metallisch leitendem Material mit einer Halbleiterschicht besteht, und daß beide Platten oder Scheiben mechanisch so zusammengesetzt sind, daß die Schnittflächen der parabolischen Erhebungen mit der entsprechend vorbehandelten Oberfläche der Halbleiter-Platte oder -Scheibe oder mit der Halbleiterschicht auf der metallisch leitenden Platte oder Scheibe elektrische bzw. photovoltaische Kontakte bilden, in denen Licht, welches durch die lichtdurchlässige Platte oder Scheibe hindurchtritt, konzentriert auftritt.

Bei der erfindungsgemäßen Anordnung ist eine Funktionsfähigkeit der Solarzellen-Anordnung erst nach dem Zusammenfügen der beiden Platten oder Scheiben gegeben, da die elektrischen bzw. photovoltaischen Kontakte erst bei diesem Zusammensetzen der Platten oder Scheiben entstehen.

Die zweite Platte oder Scheibe kann aus einkristallinem Halbleiter-Material bestehen und auf einer Seite einen p/n-Übergang und auf der anderen Seite einen sperrfreien Kontakt aufweisen.

Die zweite Platte oder Scheibe kann ferner aus Halbleitermaterial bestehen und beidseitig mit einer Isolatorschicht überzogen sein, deren Dicke kleiner als $1 \cdot 10^{-6}$ cm ist. Sowohl der photovoltaische Kontakt als auch der zweite Kontakt am Halbleiterkörper sind dann als MIS-Kontakte mit dünner Isolatorschicht (MIS) zwischen dem Metall und dem Halbleiterkörper ausgebildet. Für die beiden Seiten der Halbleiterplatte sind dann zwei Metalle mit möglichst unterschiedlicher Elektronen-Austrittsarbeit zu verwenden, die so gewählt sind, daß der photovoltaische MIS-Kontakt gleichrichtende Eigenschaften aufweist, während der zweite MIS-Kontakt sperrschichtfrei ist.

Das Halbleitermaterial kann sowohl einkristallin als auch polykristallin sein und n- oder p-Leitfähigkeit haben. Eine Solarzellen-Anordnung kann auch dadurch hergestellt werden, daß man zwischen zwei Platten aus lichturchlässigem Material mit unterschiedlicher Metallisierung der Strukturen eine Halbleiterscheibe mit dünner Isolatorschicht legt, zusammendrückt und unter Vakuum einschließt oder einschmilzt.

Die Struktur mit den parabolischen Erhebungen kann aus parallelen Wällen mit rechteckiger Basis und parabelförmigem Querschnitt bestehen.

Die parabolischen Erhebungen können sich aber auch über quadratischen Grundflächen erheben und verjüngen, so daß jeder Querschnitt durch eine Erhebung senkrecht zu einer quadratischen Grundfläche parabelförmig ist.

Die Erhebungen sind jeweils an der Stirnseite abgekappt, so daß schmale als Auflageflächen dienende Schnittflächen zustande kommen. Als lichtdurchlässiges Material für die erste Platte oder Scheibe kann anorganisches Material wie z. B. Glas, Quarz, Saphir u. a. oder organisches Material wie z. B. Polycarbonat, Epoxyd, Polyacrylnitril verwendet werden.

Der Zwischenraum zwischen den Platten oder Scheiben kann evakuiert sein, er kann aber auch mit Edelgas, Schutzgas oder mit einer konservierenden Flüssigkeit (wie z. B. Öl) gefüllt sein.

Die zweite Platte oder Scheibe kann auch als Metall oder metallischem Material bestehen und eine polykristalline Halbleiter-Schicht aus einer III/V- oder II/VI-Verbindung tragen.

Als dünne Isolatorschichten für die MIS- oder MISIM-Strukturen können thermische oder reaktiv erzeugte Oxyde, chemisch oder elektrochemisch erzeugte Oxyde, im Hochvakuum aufgedampfte oder zerstäubte Oxyde, Nitride, Sulfide, Chalkogenide usw. oder auch organische Isolatoren verwendet werden.

Für die mindestens teilweise lichtdurchlässigen metallisch leitenden Schichten können für kleine Elektronenaustrittsarbeiten (bei photovoltaischen MIS-Kontakten für p-Halbleiter und sperrfreien MIS-Kontakten für n-Halbleiter) Be, Al, Zr, Hf, Zn, Seltene Edelmetalle, $LaB_6$, $YB_6$, $GdB_6$, $WB_2$, BaSe und andere benutzt werden. Für große Elektronenaustrittsarbeiten (bei photovoltaischen MIS-Kontakten für n-Halbleiter und sperrfreien MIS-Kontakten für p-Halbleiter) können Pt, Pd, Ru, Au, Ni Cu, Fe, $TbB_6$, $EuB_6$, $SmB_6$, $MuB_6$, $TiB_6$ und andere benutzt werden. Das einfallende Sonnenlicht kann durch Linsen, Spiegel oder Fluoreszenz-Kollektoren vorkonzentriert sein.

Im folgenden soll die Erfindung an drei Ausführungsbeispielen näher erläutert werden.

Ausführungsbeispiel 1 zeigt eine Solarzellen-Anordnung der Erfindung mit einer einkristallinen Silizium-Scheibe.

Ausführungsbeispiel 2 zeigt eine Solarzellen-Anordnung der Erfindung mit einer GaAs-Schicht. Ausführungsbeispiel 3 zeigt eine Solarzellen-Anordnung der Erfindung mit polykristallinem Silizium und einer MISIM-Struktur.

Ausführungsbeispiel 1

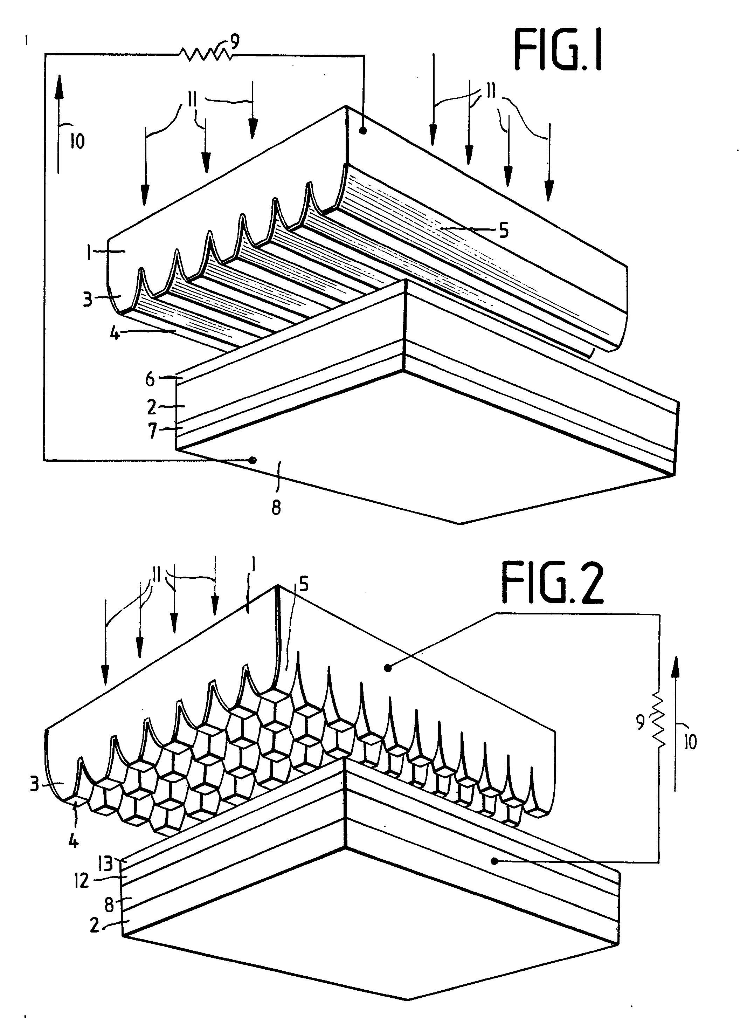

In Fig. 1 ist 1 eine Scheibe aus Polycarbonat, welche zusammen mit den parabolischen Erhebungen 3 in einem Heiß-Press-Verfahren hergestellt ist. Die parabolischen Erhebungen 3 haben eine langgestreckte rechteckige Grundfläche und verlaufen parallel zueinander. Ihre Höhe beträgt $4.10^{-2}$ cm, ihre stirnseitige Schnittfläche 4 hat eine Breite von $2.10^{-2}$ cm. 2 ist eine p-leitende einkristalline Siliziumscheibe, welche auf einer Seite eine dünne $n^+$-Schicht 6 (mit dem photovoltaischen $n^+$/p-Übergang) und auf der anderen Seite eine $p^+$-Zone 7 und einen Metallkontakt 8 hat. Die Oberfläche der parabolischen Erhebungen 3 ist mit einer lichtdurchlässigen Goldschicht 5 überzogen. Beim Zusammenpressen der Scheibe 1 und 2 bildet die Goldschicht 5 auf den Schnittflächen 4 einen elektrischen Kontakt mit der $n^+$-Schicht 6 auf der Scheibe 2. Bei Lichteinstrahlung 11 in die lichtdurchlässige Scheibe 1 erfolgt eine Konzentrierung des Lichtes 11 in den parabolischen Erhebungen 3. Das konzentrierte Licht 11 tritt durch die Schnittflächen 4 in die Oberfläche der Zone 6 auf der Scheibe 2 ein. Die dadurch erzeugte Photospannung wird zwischen der Metallschicht 5 und dem Metallkontakt 8 abgegriffen. Sie treibt den Strom 10 über den Verbraucherwiderstand 9. Die Anordnung nach Fig. 1 ist noch nicht optimal, weil etwa nur die Hälfte des $n^+$/p-Überganges 6/2 vom konzentrierten Licht 11 getroffen wird.

Ausführungsbeispiel 2

In Fig. 2 ist 1 eine Glasplatte, die über einen Heiß-Press-Prozeß auf einer Seite mit parabolischen Erhebungen 3 versehen wurde. Die Oberfläche dieser parabolischen Erhebungen ist mit einer Nickelschicht 5 überzogen, die nur an den Schnittflächen 4 lichtdurchlässig ist. 2 ist eine Graphitscheibe, welche auf einer Seite eine dünne Molybdänschicht 8 trägt. Auf der Molybdän-Schicht 8 ist eine polykristalline n-GaAs-Schicht 12 mit einer Dicke von $2.10^{-4}$ cm sperrfrei aufgebracht. Die Oberfläche der GaAs-Schicht 12 ist von einer $2.10^{-7}$ cm dicken Isolatorschicht 13 überzogen. Durch Zusammenpressen der Glas-Scheibe 1 mit der Scheibe 2 bilden die metallisierten Schnittflächen 4 mit der Oberfläche der Isolator-überzogenen GaAs-Schicht 12 einen photovoltaischen MIS-Kontakt. Das einfallende Sonnen-Licht 11 wird beispielsweise mit Hilfe einer Fresnel-Linse schon um den Faktor 5 konzentriert. Da es durch die parabolischen Erhebungen 3 noch einmal um den Faktor 4 konzentriert wird, trifft es mit etwa 20facher Intensität der Sonnenstrahlung den photovoltaischen MIS-Kontakt 4/13/12. Zwischen der Nickelschicht 5 und dem sperrfreien Molybdänkontakt 8 wird die Photospannung abgegriffen. 9 ist ein Verbraucherwiderstand und 10 der Photostrom.

Ausführungsbeispiel 3

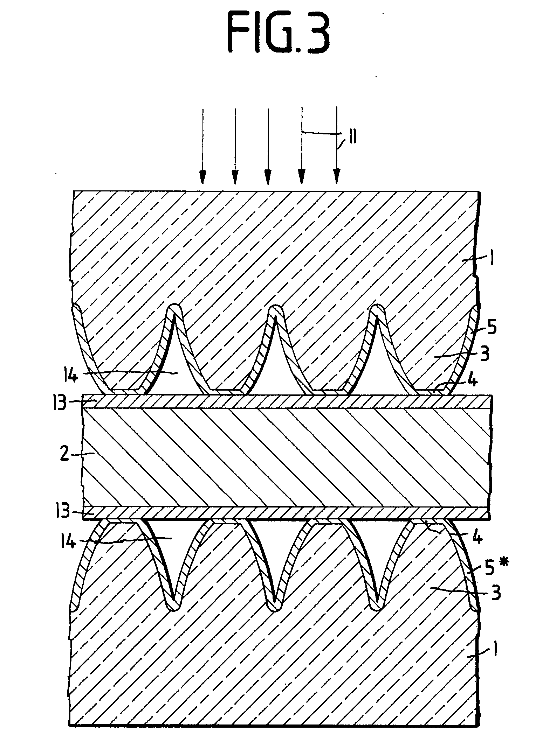

In Fig. 3 ist 2 eine polykristalline 0,5 $\Omega$cm p-Silizium-Scheibe von 10 × 10 cm² und einer Dicke von $5.10^{-2}$ cm. Sie ist vollständig mit einer thermischen $SiO_2$-Schicht 13 in einer Dicke von $1,5.10^{-7}$ cm überzogen. 1 sind zwei gleichfalls 10 × 10 cm² große Glasplatten mit einer Dicke von $1,5.10^{-1}$ cm. Von dieser Dicke

entfallen ca. $3.10^{-2}$ cm auf die Höhe der parabolischen Erhebungen 3, deren quadratische stirnseitige Schnittflächen 4 ca. $1.10^{-4}$ cm² groß sind. Die Oberfläche der parabolischen Erhebungen 3 auf der oberen Scheibe 1 sind mit einer Aluminiumschicht 5 überzogen, welche nur auf den Schnittflächen 4 lichtdurchlässig ist. Die Oberfläche der parabolischen Erhebungen 3 auf der unteren Scheibe 1 sind mit einer Nickelschicht 5* überzogen, welche nur auf den Schnittflächen 4 ebenfalls lichtdurchlässig ist. Jede Glasplatte 1 hat ca. $2,5.10^5$ parabolische Erhebungen 3. Die Siliziumscheibe 2 befindet sich zwischen den strukturierten Seiten der beiden Glasplatten 1. Da der Zwischenraum 14 zwischen den parabolischen Erhebungen 3 evakuiert ist, werden die drei Scheiben 1/2/1 durch den atmosphärischen Außendruck sehr gleichmäßg zusammengepreßt. Die Schnittflächen 4 der parabolischen Erhebungen 3 auf der oberen Scheibe 1 bilden mit der Scheibe 2 photovoltaische MIS-Kontakte. Die Schnittflächen 4 der parabolischen Erhebungen 3 auf der unteren Scheibe 1 bilden mit der Scheibe 2 sperrfreie MIS-Kontakte. Die bei der Einstrahlung von Licht 11 entstehende Photospannung wird zwischen der Aluminiumschicht 5 der oberen Platte 1 und der Nickelschicht 5* der unteren Platte 1 abgenommen.

Als Folge der parabolischen Erhebungen 3 wird das in die obere Platte 1 eingestrahlte Licht 11 etwa um den Faktor 4 konzentriert in die photovoltaischen MIS-Kontakte eingestrahlt. Dadurch ist der Wirkungsgrad der Solarzelle erhöht. Eine zusätzliche Erwärmung der MIS-Kontakte erfolgt jedoch praktisch nicht, weil die Wärmeleitung aus diesen «Punkt-Kontakten» sehr groß ist.

Durch die mit der Nickelschicht überzogenen parabolischen Erhebungen auf der unteren Platte kommen sehr gute sperrfreie MIS-Kontakte zustande, wobei durch die Isolierschicht 13 störende Minoritätsladungsträger von der Kontaktschicht 5* abgehalten werden. Der Aufbau gemäß Figur 3 hat wesentliche fertigungstechnische Vorteile, da die Halbleiterscheibe beidseitig mit einer Isolierschicht versehen wird und sowohl für die Bildung der photovoltaischen Kontakte in Verbindung mit dem Lichtkonzentrator als auch für die Bildung des Rückseitenkontaktes ein einheitlicher Körper mit parabolischen Erhebungen verwendet wird, der nur mit verschiedenartigen Metallen zu beschichten ist.

Eine komplementäre Solarzellen-Anordnung gemäß Fig. 3 läßt sich unter Verwendung einer n-Siliziumscheibe herstellen. Hierzu ist lediglich die untere Scheibe 1 in Fig. 3 mit der oberen Scheibe 1 zu vertauschen.

Mit abwechselnd p-Silizium und n-Silizium-Solarzellen-Anordnungen lassen sich Solarbatterien zusammenschalten, die besonders kleine elektrische Verbindungswege von einer Solarzelle zur anderen haben.

Mit Hilfe einer zusätzlichen äußeren Konzentration des Sonnenlichtes durch eine Fresnel-Linse, einen Spiegal oder einen Fluoreszenz-Kollektor lassen sich in der Solarzellen-Anordnung der Erfindung Gesamt-Intensitäts-Erhöhungen des Sonnenlichtes um mehr als den Faktor 10 sehr einfach realisieren. Die Solarzellen-Anordnung kann in an sich bekannter Weise gekühlt werden.

Ein ganz wesentlicher Vorteil der Solarzellen-Anordnungen nach Fig. 2 und Fig. 3 besteht darin, daß jeder photovoltaische Einzelkontakt mit den lichtdurchlässig-metallisierten Schnittflächen 4 der parabolischen Erhebungen 3 sehr kleinflächig ($1 . 10^{-4}$ cm²) ist, und noch wesentlich kleiner ausgebildet werden kann. Dadurch ist die Notwendigkeit vermieden, großflächig porenfreie Isolatorschichten 13 herstellen zu müssen.

Da die parabolischen Erhebungen 3 mit einer relativ dicken Metallschicht von z. B. einigen $10^{-4}$ cm Dicke überzogen sind (nur die Metallisierung der Schnittflächen 4 ist lichtdurchlässig), sind die Solarzellen-Anordnungen nach Fig. 2 und Fig. 3 auch sehr niederohmig.

Bezugsziffern

1 Platte oder Scheibe aus lichtdurchlässigem Material
2 Platte oder Scheibe aus Halbleiter- oder metallisch leitendem Material
3 parabolische Erhebung
4 Schnittfläche der parabolischen Erhebung
5 metallisch leitende Schicht auf Oberfläche der parabolischen Erhebung 3
6 $n^+$-Zone
7 $p^+$-Zone
8 sperrfreier Molybdän-Kontakt
9 Elektrischer Verbraucherwiderstand
10 elektrischer Strom
11 Licht-Einstrahlung
12 polykristalline n-GaAs-Schicht
13 dünne Isolatorschicht
14 Vakuum

**Patentansprüche**

1. Solarzellen-Anordnung aus mindestens zwei getrennten Platten oder Scheiben, wobei eine Platte oder Scheibe (1) aus lichtdurchlässigem Material besteht, deren eine Seite eine regelmäßige Struktur von lichtdurchlässigen Erhebungen (3) trägt, dadurch gekennzeichnet, daß sich die Erhebungen (3) parabolisch verjüngen, daß diese parabolischen Erhebungen (3) in der Höhe ihrer Brennpunkte oder ihrer Brennlinien parallel zur Oberfläche der Platte oder Scheibe abgeschnitten sind, daß die Oberfläche der parabolischen Erhebungen (3) mit einer mindestens teilweise lichtdurchlässigen elektrisch leitenden Schicht (5) überzogen ist, daß die zweite Platte oder Scheibe (2) der Anordnung aus Halbleitermaterial oder aus metallisch leitendem Material mit einer Halbleiterschicht besteht, und daß beide Platten oder Scheiben (1, 2) mechanisch so zusammengesetzt sind, daß die Schnittflächen (4) der parabolischen Erhebungen (3) mit der entsprechend vorbehandelten Oberfläche der Halbleiter-Platte oder -Scheibe (2) oder mit der Halbleiterschicht auf der metallisch leitenden Platte oder Scheibe (2) elektrische bzw. photovoltaische Kontakte bilden, in denen Licht (11), welches durch die lichtdurchlässige Platte oder Scheibe hindurchtritt, konzentriert auftritt.

2. Solarzellen-Anordnung nach Anspruch 1 dadurch gekennzeichnet, daß die parabolischen Erhebungen (3) der lichtdurchlässigen Platte oder Scheibe (1) wenigstens teilweise mit einer lichtdurchlässigen Metallschicht (5) überzogen sind, und daß die zweite Platte oder Scheibe (2) eine einkristalline Halbleiter-Platte oder -Scheibe ist, welche auf einer Oberflächenseite einen sperrfreien Kontakt (8) und unter der anderen Oberflächenseite einen p/n-Übergang (6/2) aufweist.

3. Solarzellen-Anordnung nach einem der vorhergehenden Ansprüche dadurch gekennzeichnet, daß die Halbleiter-Platte oder -Scheibe (2) von einer Isolatorschicht (13) mit einer Dicke kleiner als $1.10^{-6}$ cm überzogen ist, und daß sowohl der photovoltaische Kontakt als auch der zweite sperrfreie Kontakt am Halbleiterkörper jeweils aus einem Metall-Isolator-Halbleiter-Kontakt (MIS-Kontakt) besteht.

4. Solarzellen-Anordnung nach Anspruch 3, dadurch gekennzeichnet daß die Elektronenaustrittsarbeit der für die MIS-Kontakte vorgesehenen Metalle derart gewählt ist, daß der photovoltaische Kontakt gleichrichtende Eigenschaften aufweist, während der zweite Kontakt an der dem photovoltaischen Kontakt gegenüberliegenden Oberflächenseite der Halbleiterscheibe sperrschichtfrei ist.

5. Solarzellen-Anordnung nach einem der vorhergehenden Ansprüche dadurch gekennzeichnet, daß eine einkristalline oder polykristalline n- oder p-leitende Silizium-Platte oder -Scheibe (2), welche auf beiden Seiten mit einer dünnen Isolatorschicht (13) — vorzugsweise mit einer dünnen Quarzschicht — überzogen ist, zwischen den strukturierten Seiten zweier lichtdurchlässiger Platten oder Scheiben (1) zusammengepreßt und unter Vakuum verschlossen ist, und daß die Oberflächen oder strukturierten Seiten der lichtdurchlässigen Platten oder Scheiben dünne Metallüberzüge (5) tragen, wobei die beiden Metallüberzüge aus Metallen mit derart unterschiedlich großer Elektronen-Austrittsarbeit bestehen, daß auf der einen Seite der Halbleiterscheibe ein photovoltaischer MIS-Kontakt und auf der gegenüberliegenden Oberflächenseite des Halbleiterkörpers ein sperrschichtfreier MIS-Kontakt zustande kommt.

6. Solarzellen-Anordnung nach einem der vorhergehenden Ansprüche dadurch gekennzeichnet, daß die Struktur der parabolischen Erhebungen (3) aus parallel zueinander verlaufenden Wällen mit rechteckiger Basis besteht, wobei der Wallquerschnitt parabelförmig ist.

7. Solarzellen-Anordnung nach einem der vorhergehenden Ansprüche dadurch gekennzeichnet, daß sich die parabolischen Erhebungen (3) über quadratischen Grundflächen erheben und so verjüngen, daß jeder Querschnitt durch eine Erhebung senkrecht zu einer quadratischen Grundläche parabelförmig ist.

8. Solarzellen-Anordnung nach einem der vorhergehenden Ansprüche dadurch gekennzeichnet, daß als lichtdurchlässiges Material anorganisches Material wie z. B. Glas, Quarz, Einkristalle oder organisches Material wie z. B. Polycarbonat, Epoxydharz, Polyacrylnitril vorgesehen ist.

9. Solarzellen-Anordnung nach einem der vorhergehenden Ansprüche dadurch gekennzeichnet, daß der Zwischenraum zwischen den Platten oder Scheiben evakuiert ist oder mit Schutzgas oder einer konservierenden Flüssigkeit gefüllt ist.

10. Solarzellen-Anordnung nach einem der vorhergehenden Ansprüche dadurch gekennzeichnet, daß der Halbleiter aus einer polykristallinen Schicht aus einer III/V- oder II/VI-Verbindung besteht.

11. Solarzellen-Anordnung nach einem der vorhergehenden Ansprüche dadurch gekennzeichnet, daß die dünnen Isolatorschichten aus thermischen Oxyden, anodischen Oxyden, chemisch erzeugten oder im Hochvakuum aufgedampften oder aufgestäubten Oxyden, Nitriden, Sulfiden, Chalkogeniden usw. oder auch aus organischen Isolatoren bestehen.

12. Solarzellen-Anordnung nach einem der vorhergehenden Ansprüche dadurch gekennzeichnet, daß für die metallisch leitenden Schichten sowol Metalle als auch Verbindungen mit kleiner Elektronenaustrittsarbeit wie z. B. Be, Al, Zr, Hf, Zn, Seltene Erdmetalle, $LaB_6$, $GdB_6$, $WB_2$, BaSe und andere Metalle oder Verbindungen mit großer Elektronenaustrittsarbeit wie z. B. Pt, Pd, Ru, Au, Ni Cu, Fe, $TbB_6$, $EuB_6$, $SmB_6$, $MuB_2$, $TiB_2$ u. a. vorgesehen sind.

13. Solarzellen-Anordnung nach einem der vorhergehenden Ansprüche dadurch gekennzeichnet, daß abwechselnd eine Solarzellen-Anordnung mit einem p-Halbleiter und einem n-Halbleiter elektrisch verbunden ist.

14. Solarzellen-Anordnung nach einem der vorhergehenden Ansprüche dadurch gekennzeichnet, daß das eingestrahlte Sonnenlicht mit Hilfe einer Linse, eines Spiegels oder eines Fluoreszenz-Kollektors konzentriert ist.

15. Solarzellen-Anordnung nach einem der vorhergehenden Ansprüche dadurch gekennzeichnet, daß die Anordnung gekühlt wird.

**Claims**

1. Solar cell arrangement comprising at least two separate plates or disks, wherein one plate or disk (1) consists of light-transmitting material with one of its sides comprising a regular structure of light-transmitting elevations (3), characterized in that the elevations (3) taper parabolically, in that these parabolic elevations (3) are cut off at the level of their focal points or their focal lines parallel to the surface of the plate or disk, in that the surface of the parabolic elevations (3) is covered with an at least partially light-transmitting electrically conductive layer (5), in that the second plate or disk (2) of the arrangement consists of semiconductor material or of metallically conductive material with a semiconductor layer, and in that both plates or disks (1, 2) are combined mechanically such that the cut surfaces (4) of the parabolic elevations (3) form with the appropriately pre-treated surface of the semiconductor plate or disk (2) or with the semiconductor layer on the metallically conductive plate or disk (2) electric or photovoltaic contacts in which light (11) entering through the light-transmitting plate or disk emerges in concentrated form.

2. Solar cell arrangement as defined in claim 1, characterized in that the parabolic elevations (3) of the light-transmitting plate or disk (1) is at least partially covered with a light-transmitting metal layer (5), and in that the second plate or disk (2) is a single-crystalline semiconductor plate or disk comprising on one of its surface sides a non-blocking contact (8) and beneath the other surface side a p/n transition (6/2).

3. Solar cell arrangement as defined in one of the preceding claims, characterized in that the semiconductor plate or disk (2) is covered with an insulator layer (13) having a thickness of less than $1.10^{-6}$ cm, and in that both the photovoltaic contact and the second non-blocking contact on the semiconductor body consist of one metal-insulator semiconductor contact (MIS contact), respectively.

4. Solar cell arrangement as defined in claim 3, characterized in that the electron affinity of the metals provided for the MIS contacts is selected such that the photovoltaic contact possesses rectifying properties, whereas the second contact on the surface side of the semiconductor disk opposite the photovoltaic contact does not comprise a blocking layer.

5. Solar cell arrangement as defined in one of the preceding claims, characterized in that a single-crystalline or polycrystalline n or p conducting silicon plate or disk (2) coated on both sides with a thin insulator layer (13) — preferably with a thin quartz layer — is pressed between the structured sides of two light-transmitting plates or disks (1) and sealed under vacuum, and in that the surfaces or structured sides of the light-transmitting plates or disks comprise thin metal coatings (5), with the two metal coatings consisting of metals with electron affinities of such varying amounts that a photovoltaic MIS contact is produced on one side of the semiconductor disk and on the opposite surface side of the semiconductor body an MIS contact which does not comprise a blocking layer.

6. Solar cell arrangement as defined in one of the preceding claims, characterized in that the structure of the parabolic elevations (3) consists of walls extending parallel to one another with a rectangular base and the wall cross-section being parabolic.

7. Solar cell arrangement as defined in one of the preceding claims, characterized in that the parabolic elevations (3) rise over square base areas and taper such that each cross-section through an elevation perpendicular to a square base area is parabolic.

8. Solar cell arrangement as defined in one of the preceding claims, characterized in that inorganic material such as, for example, glass, quartz, single-crystals or organic material such as, for example, polycarbonate, epoxy resin, polyacrylonitrile is provided as light-transmitting material.

9. Solar cell arrangement as defined in one of the preceding claims, characterized in that the space between the plates or disks is evacuated or filled with protective gas or a preserving liquid.

10. Solar cell arrangement as defined in one of the preceding claims, characterized in that the semiconductor consists of a polycrystalline layer made of a III/V or II/VI compound.

11. Solar cell arrangement as defined in one of the preceding claims, characterized in that the thin insulator layers consist of thermal oxides, anodic oxides; oxides, nitrides, sulfides, chalcogenides, etc. which are chemically produced or deposited by evaporation or dusting in a high vacuum; or of organic insulators.

12. Solar cell arrangement as defined in one of the preceding claims, characterized in that both metals and compounds with low electron affinity such as, for example, Be, Al, Zr, Hf, Zn, rare earth metals, $LaB_6$, $GdB_6$, $WB_2$, BaSe and other metals or compounds with high electron affinity such as, for example, Pt, Pd, Ru, Au, Ni Cu, Fe, $TbB_6$, $EuB_6$, $SmB_6$, $MuB_2$, $TiB_2$ and others are provided for the metallically conductive layers.

13. Solar cell arrangement as defined in one of the preceding claims, characterized in that a solar cell arrangement is alternately electrically connected to a p-semiconductor and an n-semiconductor.

14. Solar cell arrangement as defined in one of the preceding claims, characterized in that the sunlight introduced is concentrated by a lens, a mirror or a fluorescence collector.

15. Solar cell arrangement as defined in one of the preceding claims, characterized in that the arrangement is cooled.

**Revendications**

1. Réseau de photopiles solaires, constitué par au moins deux plaquettes séparées dont une (1) est en matériau transparent et présente sur une face une structure régulière de protubérances (3) transparente, ledit réseau étant caractérisé en ce que les protubérances (3) se réduisent paraboliquement; ces protubérances paraboliques (3) sont découpées à la hauteur de leurs foyers ou de leurs axes focaux, parallèlement à la surface de la plaquette; la surface des protubérances paraboliques (3) est revêtue d'une couche (5) conductrice et au moins semi-transparente; la seconde plaquette (2) du réseau est en matériau semiconducteur ou en matériau métallique recouvert d'une couche semiconductrice; et les deux plaquettes (1, 2) sont assemblées mécaniquement de façon que les faces découpées (4) des protubérances paraboliques (3) forment avec la surface préalablement traitée de la plaquette semiconductrice (2) ou la couche semiconductrice sur la plaquette métallique (2) des contacts électriques ou photovoltaïques dans lesquels est concentrée la lumière ayant traversé la plaquette transparente.

2. Réseau de photopiles solaires selon revendication 1, caractérisé en ce que les protubérances paraboliques (3) de la plaquette transparente (1) sont recouvertes au moins partiellement d'une couche métallique (5) transparente; et la seconde plaquette (2) est une plaquette semiconductrice monocristalline, dont une face superficielle porte un contact (8) sans couche d'arrêt et qui présente sous l'autre face superficielle une jonction p/n (6/2).

3. Réseau de photopiles solaires selon une des revendications 1 ou 2, caractérisé en ce que la plaquette semiconductrice (2) est recouverte d'une couche isolante (13) d'une épaisseur inférieure à $1.10^{-6}$ cm; et le contact photovoltaïque et le second contact sans couche d'arrêt sur le substrat semiconducteur sont consitués chacun par un contact métal-isolant-semiconducteur (contact MIS).

4. Réseau de photopiles solaires selon revendication 3, caractérisé en ce que le travail de sortie des électrons des métaux utilisés pour les contacts MIS est choisi de façon que le contact photovoltaïque présente des propriétés de redressement, tandis que le second contact situé sur la face superficielle de la plaquette semiconductrice en regard du contact photovoltaïque, est exempt de couche d'arrêt.

5. Réseau de photopiles solaires selon une quelconque des revendications 1 à 4, caractérisé en ce qu'une plaquette (2) en silicium n ou p monoscristallin ou polycristallin est recouverte sur les deux faces d'une mince couche isolante (13), et de préférence une mince couche de quartz, assemblée sous pression entre les faces structurées de deux plaquettes (1) transparentes puis obturée sous vide; et les surfaces des faces structurées des plaquettes transparentes portent de minces revêtements métalliques (5), ces deux derniers étant réalisés avec des métaux présentant un travail de sortie des électrons suffisamment différent pour produire un contact MIS photovoltaïque sur une face de la plaquette semiconductrice et un contact MIS sans couche d'arrêt sur la face superficielle opposée de substrat semiconducteur.

6. Réseau de photopiles solaires selon une quelconque des revendications 1 à 5, caractérisé en ce que la structure de protubérances paraboliques (3) est consituée par des protubérances parallèles à base rectangulaire et de section parabolique.

7. Réseau de photopiles solaires selon une quelconque des revendications 1 à 6, caractérisé en ce que les protubérances paraboliques (3) présentent une surface de base carrée et se rétrécissent de façon que toute coupe d'une protubérance, perpendiculairement à une surface de base carrée, soit parabolique.

8. Réseau de photopiles solaires selon une quelconque des revendications 1 à 7, caractérisé par l'emploi comme matériau transparent d'un matériau minéral tel que verre, quartz, monocristaux, ou d'un matériau organique tel que polycarbonate, résine époxyde, polyacrylonitrile.

9. Réseau de photopiles solaires selon une quelconque des revendications 1 à 8, caractérisé en ce que l'espace intermédiaire compris entre les plaquettes est mis sous vide ou rempli de gaz inerte ou d'un liquide de traitement.

10. Réseau de photopiles solaires selon une quelconque des revendications 1 à 9, caractérisé en ce que le semiconducteur est consitué par une couche polycristalline d'un composé III/V ou II/VI.

11. Réseau de photopiles solaires selon une quelconque des revendications 1 à 10, caractérisé en ce que les minces couches isolantes sont constituées par des oxydes thermiques, oxydes anodiques, oxydes produits chimiquement ou évaporés ou pulvérisés sous vide poussé, nitrures, sulfures, chalcogénures, etc., ou des isolants organiques.

12. Réseau de photopiles solaires selon une quelconque des revendications 1 à 11, caractérisé par l'emploi pour les couches à conduction métallique de métaux ou de composés à faible travail de sortie des électrons, tels que Be, Al, Zr, Hf, Zn, métaux des terres rares, $LaB_6$, $GdB_6$, $WB_2$, BaSo, et d'autres métaux ou composés à fort travail de sortie des électrons, tels que Pt, Pd, Ru, Au, Ni Cu, Fe, $TbB_6$, $EuB_6$, $SmB_6$, $MuB_2$, $TiB_2$, etc.

13. Réseau de photopiles solaires selon une quelconque des revendications 1 à 12, caractérisé en ce qu'un réseau à semiconducteur p et un réseau à semiconducteur n sont alternativement connectés électriquement.

14. Réseau de photopiles solaires selon une quelconque des revendications 1 à 13, caractérisé par la concentration de la lumière solaire incidente à l'aide d'une lentille, d'un miroir ou d'un collecteur à fluorescence.

15. Réseau de photopiles solaires selon une quelconque des revendications 1 à 14, caractérisé par le refroidissement du réseau.

# FIG.1

# FIG.2

# FIG.3